(19) Europäisches Patentamt
European Patent Office
Office européen des brevets

(11) **EP 4 266 066 A1**

(12) **EUROPEAN PATENT APPLICATION**
published in accordance with Art. 153(4) EPC

(43) Date of publication:
**25.10.2023 Bulletin 2023/43**

(21) Application number: **21917301.0**

(22) Date of filing: **27.12.2021**

(51) International Patent Classification (IPC):
**G01R 23/02** *(2006.01)*     **G01R 31/00** *(2006.01)*

(52) Cooperative Patent Classification (CPC):
**G01R 23/02; G01R 31/00**

(86) International application number:
**PCT/CN2021/141637**

(87) International publication number:
**WO 2022/148261 (14.07.2022 Gazette 2022/28)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.01.2021 CN 202110013689**

(71) Applicant: **Origin Quantum Computing Technology (Hefei) Co., Ltd**
**Hefei, Anhui 230088 (CN)**

(72) Inventor: **KONG, Weicheng**
**Hefei, Anhui 230088 (CN)**

(74) Representative: **Rau, Schneck & Hübner Patentanwälte Rechtsanwälte PartGmbB**
**Königstraße 2**
**90402 Nürnberg (DE)**

(54) **TUNABLE COUPLER, CALIBRATION METHOD AND DEVICE THEREFOR, AND QUANTUM MEASUREMENT AND CONTROL SYSTEM**

(57)     Disclosed are a tunable coupler, a calibrating method and device (10) for the tunable coupler, a quantum controlling system, and a readable storage medium. The calibrating method does not directly characterize the frequency of the tunable coupler, instead, it biases magnetic flux of the tunable coupler (i.e. biasing voltage and pulse voltage) so as to complete calibration of the tunable coupler and obtain a work point of the tunable coupler where the effective coupling of the tunable coupler is off. (FIG. 1)

Obtaining a first data in which a frequency of the first superconducting qubit varies as a function of a bias voltage of the tunable coupler — S102

Performing Ramsey interference experiments on the first superconducting qubit based on a quantum state of the second superconducting qubit and a pulse voltage of the tunable coupler so as to obtain a first frequency of the first superconducting qubit — S104

Obtaining a bias voltage corresponding to the first frequency as the first bias voltage based on the first data and the first frequency, and setting the bias voltage of the tunable coupler to the first bias voltage — S106

**FIG.1**

EP 4 266 066 A1

## Description

The present disclosure claims priority to Chinese patent application No.202110013689.1 entitled "TUNABLE COUPLER AND CALIBRATING METHOD AND DEVICE THEREOF, AND QUANTUM CONTROLLING SYSTEM", filed on January 6, 2021, which is hereby incorporated by reference in its entirety.

## TECHNICAL FIELD

The present disclosure relates to the field of quantum computing, and in particular to a tunable coupler, a calibrating method and device for the tunable coupler, a quantum controlling system and a readable storage medium.

## BACKGROUND

In general, in a tunable coupler-based superconducting qubit extension architecture, the coupling between the two superconducting qubits is achieved through a fixed capacitive coupler and a tunable coupler that can tune the coupling coefficient. Coupling parameters of the tunable coupler may be positive or negative, and therefore under certain parameters, it is possible to achieve the effect of completely shutting down the coupling. The tunable coupler works by tuning the frequency of the tunable coupler to change the effective coupling between two superconducting qubits, thereby achieving isolation or two-bit gate operation. Therefore, in the research and development stage of the tunable coupler, it is necessary to know the exact correspondence between the effective coupling and the frequency of the tunable coupler, therefore achieving the calibration of operating points of the tunable coupler.

In the prior art, the frequency of the tunable coupler is actually obtained by regarding the tunable coupler as one superconducting qubit and measuring the energy spectrum of the tunable coupler. The inventor has found that characterizing the frequency of the tunable coupler in the prior art requires an additional single-cavity multi-bit co-reading technology, and in the energy spectrum experiment, a frequency source that can actually reach the operating frequency of the tunable coupler is required, which greatly increases the cost of the entire hardware system.

Therefore, how to achieve the calibration of the operating points of the tunable coupler while effectively reducing the cost of the hardware system has become an urgent technical problem in this field.

It should be noted that the information disclosed in the background part of the present application is only intended to deepen the understanding of the general background of the present application, and should not be regarded as acknowledging or in any form implying that the information constitutes the prior art known to those skilled in the art.

## SUMMARY

An objective of the present disclosure is to provide a tunable coupler, a calibrating method and device for the tunable coupler, a quantum controlling system, and a readable storage medium, which are used for solving the problem in the prior art that characterizing the frequency of the tunable coupler directly can increase the cost of the hardware system.

A calibrating method for a tunable coupler is proposed by the present disclosure, and the tunable coupler is used for coupling between two superconducting qubits which are a first superconducting qubit and a second superconducting qubit respectively;

the calibrating method comprises following steps::
obtaining a first data in which a frequency of the first superconducting qubit varies as a function of a bias voltage of the tunable coupler;
performing Ramsey interference experiments on the first superconducting qubit based on a quantum state of the second superconducting qubit and a pulse voltage of the tunable coupler so as to obtain a first frequency of the first superconducting qubit;
obtaining a bias voltage corresponding to the first frequency as the first bias voltage based on the first data and the first frequency, and setting the bias voltage of the tunable coupler to the first bias voltage.

Alternatively, said "performing Ramsey interference experiments on the first superconducting qubit based on a quantum state of the second superconducting qubit and a pulse voltage of the tunable coupler so as to obtain a first frequency of the first superconducting qubit" , comprises:

obtaining, when a quantum state of the second superconducting qubit is at |0>, a second data in which an oscillation frequency of the first superconducting qubit varies as a function of the pulse voltage;
obtaining, when a quantum state of the second superconducting qubit is at |1>, a third data in which an oscillation frequency of the first superconducting qubit varies as a function of the pulse voltage;

obtaining, when Ramsey interference experiment results of the first superconducting qubit vary minimally as a function of the pulse voltage, a corresponding frequency of the first superconducting qubit based on the second data and the third data, and the frequency of the first superconducting qubit is the first frequency.

Alternatively, said "obtaining, when Ramsey interference experiment results of the first superconducting qubit vary minimally as a function of the pulse voltage, a corresponding frequency of the first superconducting qubit based on the second data and the third data, wherein at this moment, the frequency of the first superconducting qubit is the first frequency" , comprises:

obtaining, when Ramsey interference experiment results of the first superconducting qubit vary minimally as a function of the pulse voltage, a corresponding pulse voltage as a first pulse voltage based on the second data and the third data;

obtaining, when the pulse voltage is the first pulse voltage, the frequency of the corresponding first superconducting qubit in the second data as the first frequency.

Alternatively, before obtaining the first frequency, the method further comprises:
based on the first data, obtaining a degeneracy point of the tunable coupler, and setting the bias voltage to a value corresponding to the degeneracy point.

Alternatively, before obtaining the first frequency, the method further comprises:
performing a first parameter calibration on the two superconducting quantum bits; wherein the parameter calibration includes frequency calibration, logic gate operation parameter calibration, and measurement parameter calibration.

Alternatively, after setting the bias voltage of the tunable coupler to the first bias voltage, the method further comprises:

preparing a quantum state of either of the two superconducting qubits to 10> and 11> and performing the Ramsey interference experiments on the other superconducting qubit;

obtaining a first difference between oscillation frequencies of the quantum state of the other superconducting qubit at 10> and |1>;

determining whether the first difference is within a preset range;

if yes, then setting the bias voltage at this point as an operating point of the tunable coupler;

if not, then tuning the bias voltage and returning to perform said "preparing a quantum state of either of the two superconducting qubits to 10> and |1>" .

Alternatively, tuning magnitude of the first voltage comprises:
tuning the bias voltage by using gradient descent, or Newton's method, or random walk, or evolutionary strategy based on the magnitude of the first difference.

Alternatively, before preparing a quantum state of either of the two superconducting qubits to 10> and |1> respectively, the method further comprises:
performing a second parameter calibration on the two superconducting qubits, wherein the parameter calibration includes frequency calibration, logic gate operation parameter calibration, and measurement parameter calibration

Alternatively, a pulse voltage of the tunable coupler varies between two $\pi/2$ quantum logic gates of the Ramsey interference experiments.

A calibrating device for a tunable coupler is also proposed by the present disclosure, and the tunable coupler is used for coupling between two superconducting qubits which are a first superconducting qubit and a second superconducting qubit respectively;
the calibrating device comprises:

a first data obtaining unit configured for obtaining a first data in which a frequency of the first superconducting qubit varies as a function of a bias voltage of the tunable coupler;

a first frequency obtaining unit configured for performing Ramsey interference experiments on the first superconducting qubit based on a quantum state of the second superconducting qubit and a pulse voltage of the tunable coupler so as to obtain a first frequency of the first superconducting qubit; and

a first bias voltage obtaining unit configured for obtaining a bias voltage corresponding to the first frequency as the first bias voltage based on the first data and the first frequency, and setting the bias voltage of the tunable coupler to the first bias voltage.

Alternatively, the device further comprises:

a first difference obtaining unit configured for preparing a quantum state of either of the two superconducting qubits to 10> and 11> and performing the Ramsey interference experiments on the other superconducting qubit so as to obtain a first difference between oscillation frequencies of the quantum state of the other superconducting qubit at |0> and |1>;

a determining unit configured for determining whether the first difference is within a preset range;

a processing unit configured for: in the case of receiving a result from the determining unit that the first difference is within the preset range, setting the bias voltage at this point as a work point of the tunable coupler; in the case of receiving a result from the determining unit that the first difference is not within the preset range, tuning magnitude of the bias voltage and sending tuned bias voltage to the first difference obtaining unit, such that the first difference obtaining unit then performs said "preparing a quantum state of either of the two superconducting qubits to 10> and |1>".

a tunable coupler is also proposed by the present disclosure, and the tunable coupler is used for coupling between two superconducting qubits which are a first superconducting qubit and a second superconducting qubit respectively; the tunable coupler is calibrated as follows:

obtaining a first data in which a frequency of the first superconducting qubit varies as a function of a bias voltage of the tunable coupler;

performing Ramsey interference experiments on the first superconducting qubit based on a quantum state of the second superconducting qubit and a pulse voltage of the tunable coupler so as to obtain a first frequency of the first superconducting qubit; and

obtaining a bias voltage corresponding to the first frequency as the first bias voltage based on the first data and the first frequency, and setting the bias voltage of the tunable coupler to the first bias voltage.

A quantum controlling system is also proposed by the present disclosure, and comprises the tunable coupler described in the characterization above.

A readable storage medium is also proposed by the present disclosure, and has computer programs stored thereon, and the computer programs, when executed by a processor, are capable of implementing the calibrating method for a tunable coupler described in the characterization above.

Compared with the prior art, embodiments of the present disclosure may have the following beneficial effects: In the calibrating method for the tunable coupler, in a first step, obtaining a first data in which a frequency of the first superconducting qubit varies as a function of a bias voltage of the tunable coupler; in a second step, performing Ramsey interference experiments on the first superconducting qubit with a quantum state of the second superconducting qubit and a pulse voltage of the tunable coupler and obtaining a first frequency of the first superconducting qubit, wherein the first frequency is the frequency of a corresponding first superconducting qubit when the Ramsey interference experiment results vary minimally as a function of the pulse voltage in the case that the quantum states of the second superconducting qubit are at 10> and 11> respectively; in a third step, obtaining a corresponding first bias voltage with the first data and the first frequency, and setting the bias voltage of the tunable coupler to the first bias voltage. The first bias voltage obtained at this point is the work point of the tunable coupler that is needed. The calibrating method proposed by the present disclosure does not directly characterize the frequency of the tunable coupler, but biases the magnetic flux of the tunable coupler (i.e. biasing voltage and pulse voltage) so as to complete the calibration of the tunable coupler and obtain a work point of the tunable coupler where the effective coupling of the tunable coupler is off. The calibrating method proposed by the present disclosure does not need to consider how to characterize the frequency of the tunable coupler, and therefore it does not depend on the frequency source of the working frequency of the tunable coupler, thereby effectively saving the cost of the entire hardware system.

The calibrating device for the tunable coupler, the tunable coupler, the quantum controlling system, and the readable storage medium proposed in the present disclosure are similar to the calibrating method for the tunable coupler, and thus have similar beneficial effects, which will not be repeated herein.

## BRIEF DESCRIPTION OF THE DRAWINGS

FIG. 1 is a schematic flow chart of a calibrating method for a tunable coupler according to embodiment one of the present disclosure;

FIG. 2 is a schematic flow chart of another calibrating method for a tunable coupler according to embodiment two of the present disclosure;

FIG. 3 is a schematic illustration of first data in an embodiment of the present disclosure;

FIG. 4 is a schematic illustration of second data and third data in an embodiment of the present disclosure;

FIG. 5 is a schematic structural illustration of a calibrating device for a tunable coupler according to embodiment three of the present disclosure;

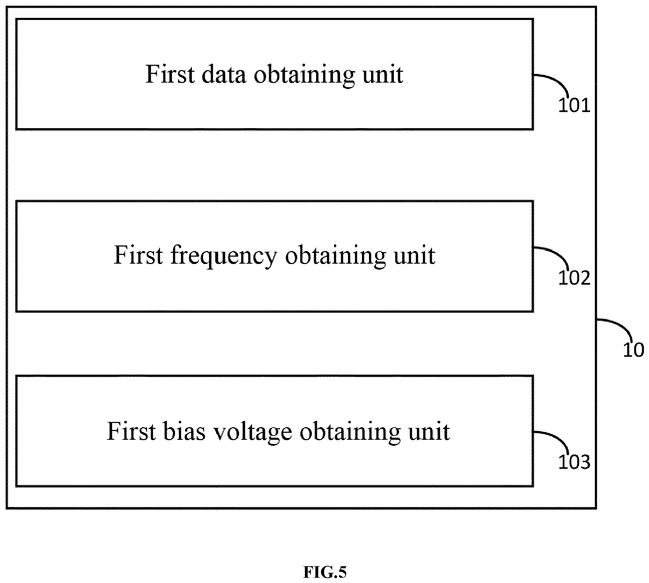

Wherein, in FIG. 5: 10-calibrating device, 101-first data obtaining unit, 102-first frequency obtaining unit, 103-first bias voltage obtaining unit.

## DETAILED DESCRIPTION

The following will be described in more detail in conjunction with the schematic illustration of the specific embodiment of the present disclosure. Based on the following description and claims, the advantages and features of the present disclosure will be clearer. It should be noted that the drawings are in a very simplified form and all use imprecise proportions, which are only used to facilitate and clearly assist the purpose of the present public embodiment.
In the description of the present disclosure, it should be understood that the orientation or position relationship indicated by the terms "center", "up", "down", "left", "right" and so on is based on the orientation or position relationship shown in the drawings, and is only for the convenience of describing the content of the present disclosure and simplifying the description, and does not indicate or imply that the device or element referred to must have a specific orientation, constructed and operated in a specific orientation, and therefore cannot be understood as a limitation to the present disclosure.
In addition, terms "first" and "second" are only for descriptive purposes, and should not be understood as indicating or implying relative importance or implying a number of indicated technical features. Therefore, features defined as "first", "second" may expressly or implicitly include at least one of those features. In the description of the present application, "plurality" means at least two, such as two, three, etc., unless expressly and specifically defined otherwise.
In order to better understand the technical solution of the present application, Ramsey interference experiments involved by the present application are briefly described below:
The Ramsey interference experiments refers to the process of applying two $\pi/2$ quantum logic gate operations to a qubit at the time interval $\tau$, applying a read pulse signal to the qubit after the second $\pi/2$ quantum logic gate operation to obtain the excited state distribution P1 ($\tau$) of the qubit, and changing the time interval $\tau$ to obtain P1 ($\tau$). The result of a typical Ramsey interference experiment is that P1 ($\tau$) satisfies the mathematical model of exponential oscillation attenuation with time interval $\tau$ as follows:

$$P_{fd}\left(\tau\right) = B + A\cos\left(2\pi f_0 \tau\right) e^{-\tau/T_0} \qquad (1)$$

In Equation 1, A and B are the fitting coefficients, $T_0$ is the decoherence time of the qubit, $f_d$ is the carrier frequency of the microwave pulse signal corresponding to the $\pi/2$ quantum logic gate operation, $f_0$ is the oscillation frequency of the qubit, and $f_0$ satisfies the following with the true frequency $f_q$ of that qubit, the carrier frequency of the $\pi/2$ quantum logic gate operation:

$$f_0(f_d) = \left| f_q - f_d \right| \qquad (2)$$

Combining the above with Equation 2, the result of the Ramsey interference experiments can be obtained, i.e., the oscillation frequency of the curve is equal to the difference between the carrier frequency of the quantum logic gate operation and the real frequency of the qubit. Thus, Ramsey interference experiments can be used to obtain not only the decoherence time of the qubit, but also the real frequency of the qubit at the same time.

## Embodiment One

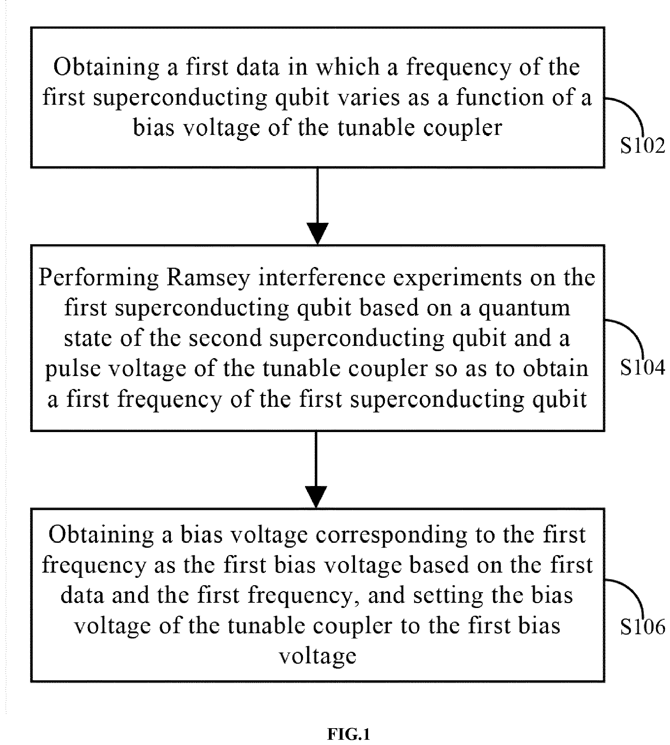

Please refer to FIG. 1, a calibrating method for a tunable coupler is proposed by an embodiment of the present disclosure, and the tunable coupler is used for coupling between two superconducting qubits which are a first superconducting qubit and a second superconducting qubit respectively. FIG. 1 is a schematic flow chart of the calibrating method for the tunable coupler described in the present embodiment, and it can be seen from FIG. 1 that the calibrating method comprises following steps:

S102: obtaining a first data in which a frequency of the first superconducting qubit varies as a function of a bias voltage of the tunable coupler;

S104: performing Ramsey interference experiments on the first superconducting qubit based on a quantum state of the second superconducting qubit and a pulse voltage of the tunable coupler so as to obtain a first frequency of the first superconducting qubit;

S 106: obtaining a bias voltage corresponding to the first frequency as the first bias voltage based on the first data and the first frequency, and setting the bias voltage of the tunable coupler to the first bias voltage.

The difference from the prior art is that the calibrating method proposed in the present embodiment does not directly characterize the frequency of the tunable coupler, but biases the magnetic flux of the tunable coupler (i.e. biasing voltage and pulse voltage) so as to complete the calibration of the tunable coupler and obtain a work point where the effective coupling of the tunable coupler is off. The calibrating method proposed by the present disclosure does not need to consider how to characterize the frequency of the tunable coupler, and therefore it does not depend on the frequency source of the working frequency of the tunable coupler, thereby effectively saving the cost of the entire hardware system. It should be understood by those skilled in the art that the magnetic flux bias includes the summation of a static bias voltage and a dynamic pulse voltage. In addition, the pulse voltage of the tunable coupler should vary between the two $\pi/2$ quantum logic gates of the Ramsey interference experiments.

In the step S102, the frequency of the first superconducting qubit may be obtained by a qubit energy spectrum experiment, and the qubit energy spectrum measurement experiment refers to applying a pulse reading signal having a frequency interval to a qubit, wherein the frequency interval comprises a plurality of frequency values having an interval. By processing the signal output by the qubit, it is possible to obtain a curve of the measured frequency of the qubit varying as a function of the frequency value of the pulse reading signal, and to determine the maximum value of the measured frequency of the qubit in the curve to be the frequency of the qubit.

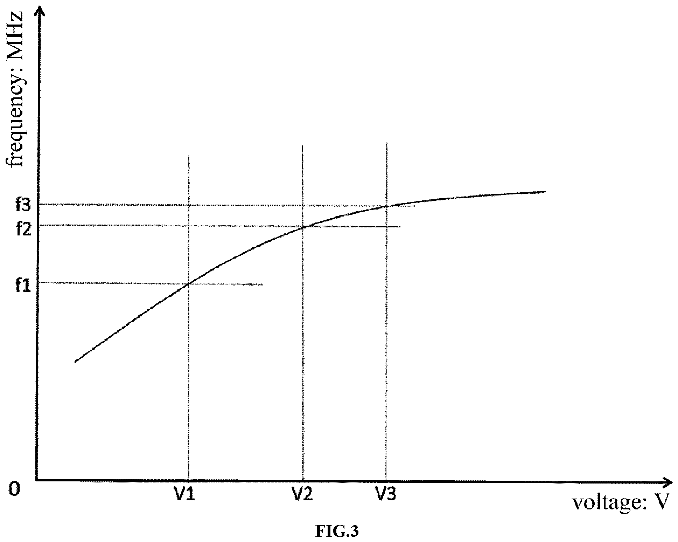

Please refer to FIG. 3, FIG. 3 is a schematic illustration of the first data proposed in an embodiment of the present disclosure, wherein the abscissa is the bias voltage of the tunable coupler, and the ordinate is the frequency of the first superconducting qubit. In combination with FIG. 3, it can be understood by those skilled in the art that the first data may be considered as a mapping relationship or functional relationship, and this mapping relationship or functional relationship comprises two parameters which are the frequency of the first superconducting qubit and the bias voltage of the tunable coupler respectively. As long as one frequency of the first superconducting qubit is determined, a corresponding bias voltage may be obtained, and vice versa. It should be noted that the first data shown in FIG. 3 is only an exemplary graphic made to facilitate a better understanding of the technical solution of the present application by those skilled in the art, and cannot be regarded as any limitation of the first data. The specific graphic of the first data needs to be tuned according to the actual statistical situation, which is not limited herein.

In step 104 of the present embodiment, a Ramsey interference experiment is performed on the first superconducting qubit based on the quantum state of the second superconducting qubit and the pulse voltage of the tunable coupler to obtain a first frequency of the first superconducting qubit. Wherein, the quantum state of the second superconducting qubit mentioned herein means that the quantum states of the second superconducting qubit is at 10> and |1> respectively, and the first frequency is the frequency of a corresponding first superconducting qubit when the Ramsey interference experiment results vary minimally as a function of the pulse voltage in the case that the quantum states of the second superconducting qubit are at 10> and |1> respectively.

In particular, the step 104 may comprise:

S1041: obtaining, when a quantum state of the second superconducting qubit is at 10>, a second data in which an oscillation frequency of the first superconducting qubit varies as a function of the pulse voltage;

S1042: obtaining, when a quantum state of the second superconducting qubit is at |1>, a third data in which an oscillation frequency of the first superconducting qubit varies as a function of the pulse voltage;

S1043: obtaining, when Ramsey interference experiment results of the first superconducting qubit vary minimally as a function of the pulse voltage, a corresponding frequency of the first superconducting qubit based on the second data and the third data, and the frequency of the first superconducting qubit is the first frequency.

It can be understood by those skilled in the art that in the step S1043, the first frequency is obtained using the second data obtained in the step S1041 and the third data obtained in the step S1042. In a specific implementation process, the sequence of obtaining the second data and the third data is not limited, the second data may be obtained first and then the third data, or the third data may be obtained first and then the second data, which can be specifically selected according to actual needs and is not limited herein.

Further, step S1043 may specifically comprise:

obtaining, when Ramsey interference experiment results of the first superconducting qubit vary minimally as a function of the pulse voltage, a corresponding pulse voltage as a first pulse voltage based on the second data and the third data;

obtaining, when the pulse voltage is the first pulse voltage, the frequency of the corresponding first superconducting qubit in the second data as the first frequency.

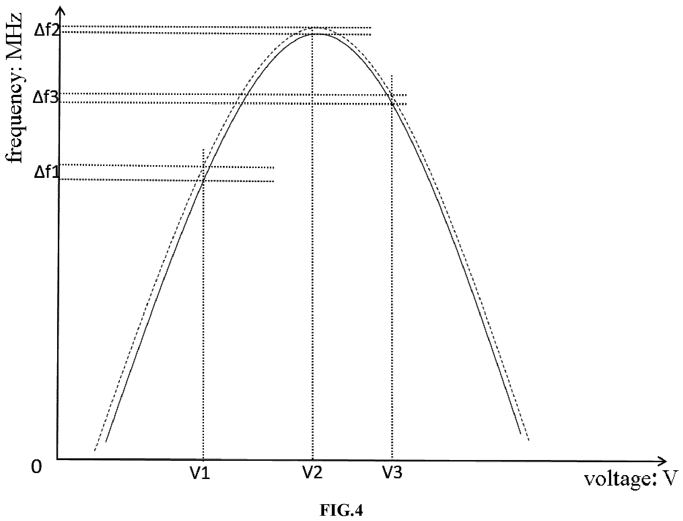

In the step S1043, obtaining, when Ramsey interference experiment results of the first superconducting qubit vary minimally as a function of the pulse voltage, a corresponding pulse voltage. Since the true frequency of the qubit may be accurately obtained by the Ramsey interference experiment results, similar to the first data, please refer to FIG. 4, the second data can be understood as a mapping relationship or function relationship in which the frequency of the first superconducting qubit varies as a function of the pulse voltage of the tunable coupler when the quantum state of the second superconducting qubit is at 10>. The mapping relationship or function relationship herein contains two parameters which are the frequency of the first superconducting qubit when the quantum state of the superconducting qubit is at 10> and the pulse voltage of the tunable coupler respectively. As long as one pulse voltage is determined, the frequency of the first superconducting qubit when the quantum state of the corresponding second superconducting qubit is at 11> is obtained. the second data can be understood as a mapping relationship or function relationship in which the frequency of the first superconducting qubit varies as a function of the pulse voltage of the tunable coupler when the quantum state of the second superconducting qubit is at 11>. The mapping relationship or function relationship herein contains two parameters which are the frequency of the first superconducting qubit when the quantum state of the superconducting qubit is at |1> and the pulse voltage of the tunable coupler respectively. As long as one pulse voltage is determined, the frequency of the first superconducting qubit when the quantum state of the corresponding second superconducting qubit is at 11> is obtained.

Further, in the step S1043, with reference to FIG. 4, FIG. 4 is a schematic illustration of a second data and a third data proposed in an embodiment of the present disclosure, wherein the abscissa of FIG. 4 is the pulse voltage of the tunable coupler, and the ordinate thereof is the frequency of the first superconducting qubit. The solid portion in FIG. 4 is the frequency of the first superconducting qubit when the quantum state of the second superconducting qubit is at |0>, and the dotted portion is the frequency of the first superconducting qubit when the quantum state of the second superconducting qubit is at |1>. How to obtain the first pulse voltage by using the second data and the third data can be understood that the frequency of the first superconducting qubit varies under the same pulse voltage when the quantum states of the second superconducting qubit are at 10> and |1>, finding out the magnitude of the pulse voltage corresponding to the smallest difference of the variation, and setting the pulse voltage at this point to the first pulse voltage. For example, in FIG. 4, when the pulse voltage of the tunable coupler is V1, the difference in the frequency of the first superconducting qubit is $\Delta f1$ at the same pulse voltage; when the pulse voltage of the tunable coupler is V2, the difference in the frequency of the first superconducting qubit is $\Delta f2$ at the same pulse voltage; when the pulse voltage of the tunable coupler is V3, the difference in the frequency of the first superconducting qubit is $\Delta f3$ at the same pulse voltage. By calculation and comparison, it can be seen that when the pulse voltage of the tunable coupler is V2, the difference in the frequency of the first superconducting qubit is minimum at the same pulse voltage, and therefore, V2 can be taken as the first pulse voltage. When the pulse voltage of the tunable coupler is V2 and the quantum state of the second qubit is at |0 >, the frequency of the first superconducting qubit can be calibrated by the oscillation frequency in the Ramsey interference experiment results, that is, using the second data when the pulse voltage of the tunable coupler is V2 and the quantum state of the second qubit is at 10>, obtaining the frequency of the first superconducting qubit corresponding to the first pulse (i.e., the first frequency). It should be noted that the second data and the third data shown in FIG. 4 are only exemplary graphics made to facilitate a better understanding of the technical solution of the present application by those skilled in the art, and cannot be regarded as any limitation of the second data and the third data. The specific graphics of the second data and the third data need to be tuned according to the actual statistical situation, which is not limited herein.

It should be noted that before obtaining the first frequency, the following steps may also be performed: based on the first data, obtaining a degeneracy point of the tunable coupler, and setting the bias voltage to a value corresponding to the degeneracy point.

It can be understood that in the embodiment of the present disclosure, setting the bias voltage on the degeneracy point before obtaining the first frequency is a reference parameter required for the convenience of subsequent steps, and does not mean that the bias voltage must be set on the degeneracy point before obtaining the first frequency. In other embodiments, the bias voltage may also be set in other positions, which is not limited herein.

Alternatively, before obtaining the first frequency, the following steps may also be performed: S101: performing a first parameter calibration on the two superconducting quantum bits; wherein the parameter calibration includes frequency calibration, logic gate operation parameter calibration, and measurement parameter calibration.

The steps S101 and S102 are not in order, that is, the step S101 may be performed first and then the step S102, or the step S 102 may be performed first and then the step 101, which is not limited herein, as long as the bias voltage of the tunable coupler can be kept consistent in the steps S101 and S104. The frequency calibration in the parameter calibration can be calibrated through an energy spectrum experiment or a Ramsey interference experiment. The logic gate operation parameter calibration refers to calibrating a regulation and control signal for the quantum bit.

The measurement parameter calibration refers to calibrating a parameter of a resonant cavity for measuring the quantum bit.

**Embodiment Two**

The inventor has found that after the tunable coupler is calibrated by using the calibrating method provided in the Embodiment One, the first bias voltage can be obtained, but due to the distortion of the tunable coupler or the influence of some other external factors, there may be an error between the first bias voltage obtained in the Embodiment One and the desired work point of the tunable coupler. Therefore, it is necessary to further calibrate the first bias voltage so as to improve the calibration accuracy of the tunable coupler.

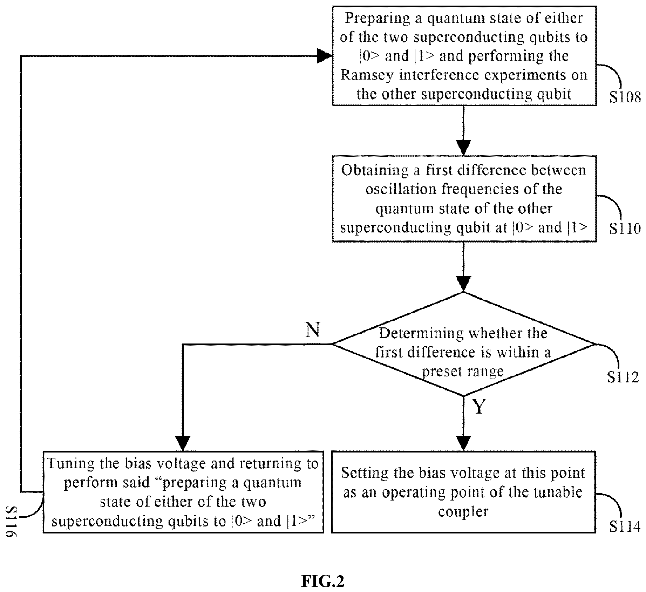

Based on the above findings, the present embodiment is mainly aimed at the further calibration of the first bias voltage obtained in the Embodiment One. It should be noted that, in the present embodiment, the steps before obtaining the first bias voltage may refer to the solution shown in the Embodiment One, which is not repeated herein. Please refer to FIG. 2, it is a schematic flow chart of the calibrating method proposed in the present embodiment, and it can be seen from FIG. 2 that the specific solution of the present embodiment is as follows:

S 108: preparing a quantum state of either of the two superconducting qubits to 10> and 11> and performing the Ramsey interference experiments on the other superconducting qubit;
S 110: obtaining a first difference between oscillation frequencies of the quantum state of the other superconducting qubit at 10> and |1>;
S112: determining whether the first difference is within a preset range;
S114: if yes, then setting the bias voltage at this point as an operating point of the tunable coupler;
S116: if not, then tuning the bias voltage and returning to perform said "preparing a quantum state of either of the two superconducting qubits to 10> and |1>".

By further calibrating the first bias voltage with the calibrating method proposed in the present embodiment, it is possible to improve the calibration accuracy of the tunable coupler to complete the setting of the magnetic flux bias of the tunable coupler, so that the effective coupling between the two superconducting qubits at this point is in the required off state, and the calibrating method is low in implementation cost and easy to expand.

Further, in the step S 116, if it is determined that the first difference exceeds the preset range, it is necessary to tune the magnitude of the bias voltage accordingly. With regard to how to tune the magnitude of the bias voltage, the following methods are given in the present embodiment: tuning the bias voltage by using gradient descent, or Newton's method, or random walk, or evolutionary strategy based on the magnitude of the first difference. These methods are briefly described below. The gradient descent is calculated by solving for the minimum along the gradient descent (or the maximum along the gradient ascending). The gradient direction can be obtained by deriving the function, and the determination of the step size is more troublesome; if the step size is too large, it may diverge; if the step size is too small, the convergence speed is too slow. In general, the method of determining the step size is determined by the linear search algorithm, because in general, if the gradient vector is 0, an extreme point has been reached, and the amplitude of the gradient is also 0. When using the gradient descent algorithm for optimization solving, the termination condition of the algorithm iteration is that the amplitude of the gradient vector approaches 0, so a very small constant threshold may be set.

The Newton's method is second-order convergence, and gradient descent is first-order convergence, so the Newton's method is faster. To put it more generally, for example, if you want to find the shortest path to the bottom of a basin, the gradient descent takes one step at a time in the direction of the largest slope from your current location. When choosing a direction, the Newton's method will not only consider whether the slope is large enough, but also whether the slope will become larger after you take a step. So, it can be said that the Newton's method both sees a little further than the gradient descent and gets to the bottom more quickly. By comparison, the vision of the Newton's method is more long-term, and therefore less detours; relatively speaking, the gradient descent only considers the local optimum without global thinking.

The random walk is the simplest of the local search algorithms, and its basic strategy is to select a better one from the neighbors of the current candidate solution for transfer each time. Each time a neighborhood point of the current solution is randomly selected for comparison, and if it is better than the current solution, then that point is used as the new center. If no better value is found for N consecutive times, it is considered that the optimal solution lies in the N-dimensional ball centered on the current optimal solution and with the radius of the current step. At this point, if the step size is already less than the threshold, the algorithm ends; otherwise, the step size is halved and a new round of walking begins.

Natural selection in the evolutionary strategy is done in a deterministic way, as opposed to random selection in genetic algorithms and evolutionary planning. Recombinant operators are provided in the evolutionary strategy, but recombination in evolutionary strategies is different from swapping in genetic algorithms. That is, instead of swapping a part of an individual, each part of the individual is combined, and each part of the new individual contains the corresponding information from the two old individuals.

Of course, in addition to the methods listed in the present embodiment to tune the bias voltage, there are many other methods for selection, which is not repeated herein. In addition, when tuning the bias voltage, in addition to selecting one of these methods for processing, it is also possible to choose a combination of multiple methods for processing, which is not limited here and can be selected according to actual needs.

Alternatively, before preparing a quantum state of either of the two superconducting qubits to 10> and |1> respectively, further comprises:

A second parameter calibration is performed on the two superconducting qubits. Specifically, frequencies of the two superconducting qubits are calibrated a second time.

**Embodiment Three**

A calibrating device 10 for a tunable coupler is proposed in the present embodiment, and the tunable coupler is used for coupling between two superconducting qubits which are a first superconducting qubit and a second superconducting qubit respectively;

please refer to FIG. 5, the calibrating device 10 comprises:
a first data obtaining unit 110 configured for obtaining a first data in which a frequency of the first superconducting qubit varies as a function of a bias voltage of the tunable coupler;
a first frequency obtaining unit 102 configured for obtaining a first frequency of the first superconducting qubit, the first frequency being the frequency of a corresponding first superconducting qubit when the Ramsey interference experiment results vary minimally as a function of the pulse voltage in the case that the quantum states of the second superconducting qubit are at |0> and |1> respectively;
a first bias voltage obtaining unit 103 configured for obtaining a bias voltage corresponding to the first frequency as the first bias voltage based on the first data and the first frequency, and setting the bias voltage of the tunable coupler to the first bias voltage.

It should be understood that the first data obtaining unit 101, the first frequency obtaining unit 102 and the first bias voltage obtaining unit 103 may be combined and implemented in one device, or any one of the modules may be split into multiple sub-modules, or, the at least part of the functions of one or more modules of the first data obtaining unit 101, the first frequency obtaining unit 102 and the first bias voltage obtaining unit 103 may be combined with at least part of the functions of other modules and implemented in one function module. According to an embodiment of the present disclosure, at least one of the first data obtaining unit 101, the first frequency obtaining unit 102, and the first bias voltage obtaining unit 103 may be at least partially implemented as a hardware circuit, such as a field programmable gate array (FPGA), programmable logic array (PLA), system on a chip, system on a substrate, system on a package, application specific integrated circuit (ASIC), or may be implemented by hardware or firmware in any other reasonable way of integrating or packaging circuits, or may be implemented by an appropriate combination of software, hardware and firmware. Alternatively, at least one of the first data obtaining unit 101, the first frequency obtaining unit 102, and the first bias voltage obtaining unit 103 may be at least partially implemented as a computer program module, and when the program is run by a computer, the functions of the corresponding modules may be performed.

Specifically, the calibrating device for a tunable coupler further comprises:

a first difference obtaining unit configured for preparing a quantum state of either of the two superconducting qubits to 10> and |1> and performing the Ramsey interference experiments on the other superconducting qubit so as to obtain a first difference between oscillation frequencies of the quantum state of the other superconducting qubit at 10> and |1>;
a determining unit configured for determining whether the first difference is within a preset range;
a processing unit configured for: in the case of receiving a result from the determining unit that the first difference is within the preset range, setting the bias voltage at this point as a work point of the tunable coupler; in the case of receiving a result from the determining unit that the first difference is not within the preset range, tuning magnitude of the bias voltage and sending tuned bias voltage to the first difference obtaining unit, such that the first difference obtaining unit then performs said "preparing a quantum state of either of the two superconducting qubits to |0> and |1>".

## Embodiment Four

a tunable coupler is proposed in the present embodiment, and the tunable coupler is used for coupling between two superconducting qubits which are a first superconducting qubit and a second superconducting qubit respectively; the tunable coupler is calibrated as follows:

obtaining a first data in which a frequency of the first superconducting qubit varies as a function of a bias voltage of the tunable coupler;

obtaining a first frequency, the first frequency being the frequency of a corresponding first superconducting qubit when the Ramsey interference experiment results vary minimally as a function of the pulse voltage in the case that the quantum states of the second superconducting qubit are at $|0>$ and $|1>$ respectively;

obtaining a bias voltage corresponding to the first frequency as the first bias voltage based on the first data and the first frequency, and setting the bias voltage of the tunable coupler to the first bias voltage.

A quantum controlling system is also proposed in the present embodiment, and comprises the tunable coupler described above.

## Embodiment Five

A readable storage medium is provided by the present embodiment, which has computer programs stored thereon, and the computer programs when executed by a processor are capable of implementing the method for calibrating a tunable coupler.

The computer readable storage medium may be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. Computer readable program instructions described herein may be downloaded to respective computing/processing devices from a computer readable storage medium or to an external computer or external storage device via a network, for example, the Internet, a local area network, a wide area network and/or a wireless network. The network may include copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of the present disclosure may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, systems, and computer program products according to embodiments of the invention. It will be understood that each block of the flowchart illustrations and/or block diagrams, and combinations of blocks in the flowchart illustrations and/or block diagrams, may be implemented by computer readable program instructions. These computer readable program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein includes an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

In the description of the present specification, the description of the terms "one embodiment", "some embodiments", "examples" or "specific examples" and the like refers to at least one embodiment or example included in the present disclosure in conjunction with the specific features, structures, materials, or characteristics described in the present embodiment or example. In the present specification, the schematic expression of the above terms does not have to refer to the same embodiment or example. Further, the specific features, structures, materials, or characteristics described may be combined in a suitable manner in any one or more embodiments. Further, those skilled in the art may be joined and combined with different embodiments or examples described in the present specification.

The foregoing is only a preferred embodiment of the present disclosure and does not have any limiting effect on the present disclosure. Any technical person in the art who belongs to the field of the present disclosure, within the scope of the technical solution that does not depart from the present disclosure, makes any form of equivalent replacement or modification of the technical solution and technical content disclosed in the present disclosure, which is the content of the technical solution that is not separated from the present disclosure, and still falls within the scope of protection of the present disclosure.

**Claims**

1. A calibrating method for a tunable coupler, **characterized in that** the tunable coupler is used for coupling between two superconducting qubits which are a first superconducting qubit and a second superconducting qubit respectively; the calibrating method comprises the following steps:

   obtaining a first data in which a frequency of the first superconducting qubit varies as a function of a bias voltage of the tunable coupler;
   performing Ramsey interference experiments on the first superconducting qubit based on a quantum state of the second superconducting qubit and a pulse voltage of the tunable coupler so as to obtain a first frequency of the first superconducting qubit; and
   obtaining a bias voltage corresponding to the first frequency as the first bias voltage based on the first data and the first frequency, and setting the bias voltage of the tunable coupler to the first bias voltage.

2. The calibrating method of claim 1 for a tunable coupler, **characterized in that**, said "performing Ramsey interference experiments on the first superconducting qubit based on a quantum state of the second superconducting qubit and a pulse voltage of the tunable coupler so as to obtain a first frequency of the first superconducting qubit", comprises:

   obtaining, when a quantum state of the second superconducting qubit is at 10>, a second data in which an oscillation frequency of the first superconducting qubit varies as a function of the pulse voltage;
   obtaining, when a quantum state of the second superconducting qubit is at |1>, a third data in which an oscillation frequency of the first superconducting qubit varies as a function of the pulse voltage; and
   obtaining, when Ramsey interference experiment results of the first superconducting qubit vary minimally as a function of the pulse voltage, a corresponding frequency of the first superconducting qubit based on the second data and the third data, wherein at this moment, the frequency of the first superconducting qubit is the first frequency.

3. The calibrating method of claim 2 for a tunable coupler, **characterized in that**, said "obtaining, when Ramsey interference experiment results of the first superconducting qubit vary minimally as a function of the pulse voltage, a corresponding frequency of the first superconducting qubit based on the second data and the third data, wherein at this moment, the frequency of the first superconducting qubit is the first frequency", comprises:

obtaining, when Ramsey interference experiment results of the first superconducting qubit vary minimally as a function of the pulse voltage, a corresponding pulse voltage as a first pulse voltage based on the second data and the third data;

obtaining, when the pulse voltage is the first pulse voltage, the frequency of the corresponding first superconducting qubit in the second data as the first frequency.

4. The calibrating method of claim 1 for a tunable coupler, **characterized in that**, before obtaining the first frequency, further comprises:

based on the first data, obtaining a degeneracy point of the tunable coupler, and setting the bias voltage to a value corresponding to the degeneracy point.

5. The calibrating method of claim 1 for a tunable coupler, **characterized in that**, before obtaining the first frequency, further comprises:

performing a first parameter calibration on the two superconducting qubits; wherein a parameter calibration includes frequency calibration, logic gate operation parameter calibration, and measurement parameter calibration.

6. The calibrating method of claim 1 for a tunable coupler, **characterized in that**, after setting the bias voltage of the tunable coupler to the first bias voltage, further comprises:

preparing a quantum state of either of the two superconducting qubits to 10> and |1> and performing the Ramsey interference experiments on the other superconducting qubit;

obtaining a first difference between oscillation frequencies of the quantum state of the other superconducting qubit at 10> and |1>;

determining whether the first difference is within a preset range;

if yes, then setting the bias voltage at this point as an operating point of the tunable coupler;

if not, then tuning the bias voltage and returning to perform said "preparing a quantum state of either of the two superconducting qubits to 10> and |1>".

7. The calibrating method of claim 6 for a tunable coupler, **characterized in that**, tuning magnitude of the first voltage comprises:

tuning the bias voltage by using gradient descent, or Newton's method, or random walk, or evolutionary strategy based on the magnitude of the first difference.

8. The calibrating method of claim 6 for a tunable coupler, **characterized in that**, before preparing a quantum state of either of the two superconducting qubits to 10> and |1> respectively, further comprises:

performing a second parameter calibration on the two superconducting qubits, wherein the parameter calibration includes frequency calibration, logic gate operation parameter calibration, and measurement parameter calibration.

9. The calibrating method of claim 1 for a tunable coupler, **characterized in that**, a pulse voltage of the tunable coupler varies between two $\pi/2$ quantum logic gates of the Ramsey interference experiments.

10. A calibrating device for a tunable coupler, **characterized in that**, the tunable coupler is used for coupling between two superconducting qubits which are a first superconducting qubit and a second superconducting qubit respectively; the calibrating device comprises:

a first data obtaining unit configured for obtaining a first data in which a frequency of the first superconducting qubit varies as a function of a bias voltage of the tunable coupler;

a first frequency obtaining unit configured for performing Ramsey interference experiments on the first superconducting qubit based on a quantum state of the second superconducting qubit and a pulse voltage of the tunable coupler so as to obtain a first frequency of the first superconducting qubit; and

a first bias voltage obtaining unit configured for obtaining a bias voltage corresponding to the first frequency as the first bias voltage based on the first data and the first frequency, and setting the bias voltage of the tunable coupler to the first bias voltage.

11. The calibrating device of claim 10 for a tunable coupler, **characterized by** further comprising:

a first difference obtaining unit configured for preparing a quantum state of either of the two superconducting qubits to 10> and 11> and performing the Ramsey interference experiments on the other superconducting qubit so as to obtain a first difference between oscillation frequencies of the quantum state of the other superconducting qubit at 10> and |1>;

a determining unit configured for determining whether the first difference is within a preset range;

a processing unit configured for: in the case of receiving a result from the determining unit that the first difference is within the preset range, setting the bias voltage at this point as a work point of the tunable coupler; in the case of receiving a result from the determining unit that the first difference is not within the preset range, tuning magnitude of the bias voltage and sending tuned bias voltage to the first difference obtaining unit, such that the first difference obtaining unit then performs said "preparing a quantum state of either of the two superconducting qubits to 10> and |1>".

12. A tunable coupler, **characterized in that** the tunable coupler is used for coupling between two superconducting qubits which are a first superconducting qubit and a second superconducting qubit respectively;

the tunable coupler is calibrated as follows:

obtaining a first data in which a frequency of the first superconducting qubit varies as a function of a bias voltage of the tunable coupler;

performing Ramsey interference experiments on the first superconducting qubit based on a quantum state of the second superconducting qubit and a pulse voltage of the tunable coupler so as to obtain a first frequency of the first superconducting qubit; and

obtaining a bias voltage corresponding to the first frequency as the first bias voltage based on the first data and the first frequency, and setting the bias voltage of the tunable coupler to the first bias voltage.

13. A quantum controlling system, **characterized by** comprising the tunable coupler of claim 12.

14. A readable storage medium having computer programs stored thereon, **characterized in that** the computer programs, when executed by a processor, are capable of implementing the calibrating method of any one of claims 1 to 9 for a tunable coupler.

Obtaining a first data in which a frequency of the first superconducting qubit varies as a function of a bias voltage of the tunable coupler

S102

Performing Ramsey interference experiments on the first superconducting qubit based on a quantum state of the second superconducting qubit and a pulse voltage of the tunable coupler so as to obtain a first frequency of the first superconducting qubit

S104

Obtaining a bias voltage corresponding to the first frequency as the first bias voltage based on the first data and the first frequency, and setting the bias voltage of the tunable coupler to the first bias voltage

S106

**FIG.1**

Preparing a quantum state of either of the two superconducting qubits to $|0\rangle$ and $|1\rangle$ and performing the Ramsey interference experiments on the other superconducting qubit — S108

Obtaining a first difference between oscillation frequencies of the quantum state of the other superconducting qubit at $|0\rangle$ and $|1\rangle$ — S110

Determining whether the first difference is within a preset range — S112

N

Tuning the bias voltage and returning to perform said "preparing a quantum state of either of the two superconducting qubits to $|0\rangle$ and $|1\rangle$" — S116

Y

Setting the bias voltage at this point as an operating point of the tunable coupler — S114

**FIG.2**

FIG.3

**FIG.4**

First data obtaining unit

101

First frequency obtaining unit

102

10

First bias voltage obtaining unit

103

**FIG.5**

## INTERNATIONAL SEARCH REPORT

| International application No. |
| --- |
| **PCT/CN2021/141637** |

### A. CLASSIFICATION OF SUBJECT MATTER

G01R 23/02(2006.01)i; G01R 31/00(2006.01)i

According to International Patent Classification (IPC) or to both national classification and IPC

### B. FIELDS SEARCHED

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT; IEEE: 合肥本源量子计算科技, 孔伟成, 量子, 比特, 耦合, 校准, 校正, 频率, 偏置, Ramsey, quantum, qubit, coupl+, calibrat+, correct+, adjust+, frequency, offset, bias

### C. DOCUMENTS CONSIDERED TO BE RELEVANT

| Category* | Citation of document, with indication, where appropriate, of the relevant passages | Relevant to claim No. |
| --- | --- | --- |
| A | CN 108475353 A (INTERNATIONAL BUSINESS MACHINES CORPORATION) 31 August 2018 (2018-08-31) description, paragraphs [0015]-[0030], and figures 1-3 | 1-14 |
| A | CN 110488091 A (HEFEI ORIGIN QUANTUM COMPUTING TECHNOLOGY CO., LTD.) 22 November 2019 (2019-11-22) entire document | 1-14 |
| A | CN 111091195 A (BEIJING BAIDU NETCOM SCIENCE AND TECHNOLOGY CO., LTD.) 01 May 2020 (2020-05-01) entire document | 1-14 |
| A | WO 2018236922 A1 (RIGETTI & CO INC) 27 December 2018 (2018-12-27) entire document | 1-14 |
| A | US 10097186 B1 (EPSTEIN RYAN J et al.) 09 October 2018 (2018-10-09) entire document | 1-14 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **20 February 2022** | **08 March 2022** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/141637**

| Patent document cited in search report | | | Publication date (day/month/year) | Patent family member(s) | | | Publication date (day/month/year) |
|---|---|---|---|---|---|---|---|
| CN | 108475353 | A | 31 August 2018 | US | 2017193388 | A1 | 06 July 2017 |
| | | | | US | 10467544 | B2 | 05 November 2019 |
| | | | | DE | 112016004439 | T5 | 05 July 2018 |
| | | | | WO | 2017115160 | A1 | 06 July 2017 |
| | | | | JP | 6864812 | B2 | 28 April 2021 |
| | | | | GB | 2560675 | A | 19 September 2018 |
| | | | | JP | 2019508876 | W | 28 March 2019 |
| CN | 110488091 | A | 22 November 2019 | CN | 110488091 | B | 08 June 2021 |
| CN | 111091195 | A | 01 May 2020 | US | 2021192380 | A1 | 24 June 2021 |
| | | | | AU | 2020230228 | A1 | 08 July 2021 |
| | | | | AU | 2020230228 | B2 | 30 September 2021 |
| | | | | JP | 2021103510 | A | 15 July 2021 |
| WO | 2018236922 | A1 | 27 December 2018 | US | 2020204181 | A1 | 25 June 2020 |
| | | | | US | 11108398 | B2 | 31 August 2021 |
| | | | | EP | 3642959 | A1 | 29 April 2020 |
| | | | | EP | 3642959 | A4 | 20 January 2021 |
| | | | | US | 2019007051 | A1 | 03 January 2019 |
| | | | | US | 10483980 | B2 | 19 November 2019 |
| US | 10097186 | B1 | 09 October 2018 | CA | 3091346 | A1 | 06 September 2019 |
| | | | | AU | 2019228454 | A1 | 03 September 2020 |
| | | | | AU | 2019228454 | B2 | 29 July 2021 |
| | | | | EP | 3759657 | A1 | 06 January 2021 |
| | | | | KR | 20200126411 | A | 06 November 2020 |
| | | | | WO | 2019168708 | A1 | 06 September 2019 |
| | | | | JP | 2021515396 | W | 17 June 2021 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110013689